Europäisches Patentamt

European Patent Office

Office européen des brevets

(19)

(11) Veröffentlichungsnummer: **0 103 225
B1**

(12) **EUROPÄISCHE PATENTSCHRIFT**

(45) Veröffentlichungstag der Patentschrift:
04.02.87

(51) Int. Cl.⁴: **G 03 C 1/68, C 08 F 291/18**

(21) Anmeldenummer: **83108447.0**

(22) Anmeldetag: **27.08.83**

(54) Fotolacke zur Ausbildung von Reliefstrukturen aus hochwärmebeständigen Polymeren.

(30) Priorität: **13.09.82 DE 3233912**

(43) Veröffentlichungstag der Anmeldung:
**21.03.84 Patentblatt 84/12**

(45) Bekanntmachung des Hinweises auf die Patenterteilung:
**04.02.87 Patentblatt 87/6**

(84) Benannte Vertragsstaaten:
**AT CH DE FR GB IT LI NL SE**

(56) Entgegenhaltungen:
**EP-A-0 047 184
DE-A-2 308 830
DE-A-2 437 368
DE-A-2 914 619
US-A-3 081 168**

(73) Patentinhaber: **Merck Patent Gesellschaft mit
beschränkter Haftung, Frankfurter Strasse 250,
D-6100 Darmstadt (DE)**

(72) Erfinder: **Klug, Rudolf, Dr., Grünewaldstrasse 25,
D-8750 Aschaffenburg (DE)**
Erfinder: **Härtner, Hartmut, Dr., Mathildenweg 9,
D-6109 Mühltal (DE)**
Erfinder: **Merrem, Hans-Joachim, Dr., Grüner
Weg 1, D-6104 Seeheim (DE)**
Erfinder: **Neisius, Karl Heinz, Dr., Kattreinstrasse
76, D-6100 Darmstadt (DE)**

## Beschreibung

Die Erfindung betrifft Fotolacke mit erhöhter Lichtempfindlichkeit zur Ausbildung von Reliefstrukturen aus hochwärmebeständigen Polymeren.

Fotolacke zur Ausbildung von Reliefstrukturen aus hochwärmebeständigen Polymeren werden in großem Umfang bei der Herstellung elektrischer und elektronischer Bauelemente, von Ätzreserv en und Galvanikreserven oder von Druckformen verwendet. Für diese Zwecke gut verwendbare Fotolacke sind z. B. in der DE-A- 2 308 830 beschrieben. Diese enthalten strahlungsempfindliche polymere Vorstufen. Sie werden auf ein Substrat in Form einer Schicht oder Folge aufgetragen, die Schicht oder Folge wird getrocknet und dann durch eine Negativvorlage bestrahlt. An den bestrahlten Stellen findet dadurch eine Vernetzung statt, die die Löslichkeit des aufgetragenen Materials dort drastisch verringert. Die nicht bestrahlten Schicht- oder Follenteile werden dann in geeigneter Weise durch Herauslösen oder Abziehen entfernt; die verbleibenden Reliefstrukturen können dann durch Tempern in hochwärmebeständige Polymere übergeführt werden, die Temperaturen von 250 - 400 ° ohne nachteilige Auswirkung auf Kantenschärfe und Auflösungsvermögen überstehen.

Gemäß der DE-A- 2 308 830 sind die löslichen polymeren Vorstufen (Präpolymeren) Polyadditions- oder Polykondensatgonsprodukte aus (a) carbocyclischen oder heterocyclgschen Verbindungen mit zwei zu Polyadditions- oder Polykondensationsreaktionen befähigten funktionellen Gruppen sowie teilweise in ortho- oder peri-Stellung dazu esterartig an Carboxylgruppen gebundenen strahlungsreaktiven Resten (im folgenden Ringverbindungen I genannt) und (b) mit diesen funktionellen Gruppen umsetzbare Diamine, Diisocyanate, Bis-säurechloride oder Dicarbonsäuren, die mindestens ein cyclisches Strukturelement enthalten (im folgenden Ring erbindungen II genannt). In der DE-A- 2 308 830 sind eine Anzahl strahlungsreaktiver Reste aufgezählt, die für die Vernetzung des Fotolackes bei der Bestrahlung verantwortlich sind. Es wurde jedoch gefunden, daß zur ausreichenden Vernetzung dieser Fotolacke bei Bestrahlung mit einer üblichen UV-Strahlenquelle Bestrahlungszeiten von etwa 5 Minuten, meist sogar 8 bis 15 Minuten, erforderlich sind,- diese Zeiten lassen sich auch durch übliche Fhotosensibilisatoren nicht nennenswert verkürzen. Gemäß dem Zusatzpatent DE-A- 2 437 348 werden die Fotolacke nach der DE-A- 2 308 830 dahingehend modifiziert, daß als strahlungsreaktive Gruppen Oxyalkylacrylat- bzw. Oxyalkylmethacrylatgruppen in die Ringverbindungen I eingebaut werden. Hierdurch wird eine Reduktion der notwendigen Bestrahlungszeiten auf durchschnittlich etwa 3 Minuten erreicht. Auch dies ist jedoch für die Verwendung derartiger Fotolacke in der Massenproduktion elektronischer Bauteile noch eine unerwünscht lange Bestrahlungsdauer.

Eine Steigerung der Lichtempfindlichkeit von Fotolacken enthaltend lösliche, strahlungsreaktive Polyamidester-Harze durch gleichzeitigen Zusatz von strahlungsempfindlichen, polymerisierbaren, polyfunktionellen Acrylatverbindungen und von aromatischen halogensubstituierten Bisimidazol-Photoinitiatoren wird ferner in der EP-A- 47 184 beschrieben. Solche Fotolacke zeigen zwar eine gute Lichtempfindlichkeit, der Zusatz der Bisimidazol-Photoinitiatoren hat jedoch Nachteile. So kann beispielsweise der Zusatz von Bisimidazol-Verbindungen zu einer unerwünschten, vorzeitigen Polyimidbildung in Lösung führen, wodurch die Haltbarkeit der Fotolacklösung beträchtlich verringert wird. Auch können beispielsweise bei der späteren Aushärtung der Reliefstrukturen bei hohen Temperaturen die Halogensubstituenten abgespalten werden und ihrerseits zu einer unerwünschten Beeinflussung der Materialien, besonders der Substrate, führen. Ferner neigen auch strahlungsempfindliche Acrylatverbindungen, insbesondere die in der EP-A- 47 184 genannten, zu vorzeitiger Polymerisation, wodurch ebenfalls die Stabilität solcher Fotolachlösungen deutlich beeinträchtigt wird.

Aufgabe der vorliegenden Erfindung ist somit die Modifizierung solcher Fotolacke derart, daß eine ausreichende Vernetzung der damit hergestellten Folien oder Schichten schon nach deutlich kürzeren Besstrahlungszeiten erzielt wird, die Stabilität der Fotolacklösungen sowie die Weiterverarbeitung der Fotolache und die Eigenschaften der erhaltenen Produkte jedoch durch die Modifizierung nicht beeinträchtigt werden.

Es wurde nun gefunden, daß überraschenderweise deutlich kürzere Bestrahlungszeiten bei derartigen Fotolacken ausreichend sind und auch die chemische, thermische und mechanische Beständigkeit der Fotolacke sowie der daraus hergestellten Reliefstrukturen aus hochwärmebeständigen Polymeren den in der Praxis gestellten hohen Anforderungen entsprechen, wenn man solchen Fotolacken zusätzlich mindestens eine strahlungsreaktive, polymerisierbare Allylverbindung, die einen Siedepunkt über 180° aufweist und in der die Allylgruppe(n) über ein Sauerstoff-, Schwefel und/oder Stickstoffatom gebunden ist (sind), zusetzt. Dabei wird eine deutliche Verkürzung der notwendigen Bestrahlungsdauer bereits beobachtet, wenn den bekannten, esterartig an Carboxylgruppen gebundene strahlungsreaktive Reste tragenden, löslichen polymeren Vorstufen nur eine geringe Menge von strahlungsreaktiven, polymerisierbaren Allylverbindungen, die einen Siedepunkt über 180° aufweisen und in denen die Allylgruppe(n) über einen Sauerstoff-, Schwefel-und/oder Stickstoffatom gebunden ist (sind) beigefügt wird.

Gegenstand der Erfindung sind somit Fotolacke zur Ausbildung von Reliefstrukturen aus hochwärmebeständigen Polymeren, enthaltend esterartig an Carboxylgruppen gebundene strahlungsreaktive Reste tragende, lösliche polymere Vorstufen, die dadurch gekennzeichnet sind, daß zusätzlich mindestens eine strahlungsreaktive, polymerisierbare Allylverbindung, die einen Siedepunkt über 180° aufweist und in der die Allylgruppe(n) über ein Sauerstoff-, Schwefel- und/oder Stickstoffatom gebunden ist (sind), enthalten ist.

Gegenstand der Erfindung ist ferner die Verwendung von strahlungsreaktiven, polymerisierbaren Allylverbindungen, die einen Siedepunkt über 180° aufweisen und in denen die Allylgruppe(n) über ein Sauerstoff-, Schwefel- und/ oder Stickstoffatom gebunden ist (sind), in Fotolacken zur Ausbildung von Reliefstrukturen aus hochwärmebeständigen Polymeren, enthaltend esterartig an Carboxylgruppen gebundene strahlungsreaktive Reste tragende, lösliche polymere Vorstufen.

Gegenstand der Erfindung ist weiterhin ein Verfahren zur Herstellung von Reliefstrukturen aus hochwärmebeständigen Polymeren durch Auftragen von Fotolacken, enthaltend esterartig an Carboxylgruppen gebundene strahlungsreaktive Reste tragende, lösliche polymere Vorstufen, in Form einer Schicht oder Folie auf ein Substrat, Trocknen der Schicht oder Folie, Bestrahlen der strahlungsempfindlichen Schicht oder Folie durch Negativvorlagen, Herauslösen oder Abziehen der nicht bestrahlten Schicht- oder Folienteile und gegebenenfalls anschließendes Tempern der erhaltenen Reliefstrukturen, das dadurch gekennzeichnet ist, daß man Fotolacke verwendet, in denen zusätzlich mindestens eine strahlungsreaktive, polymerisierbare Allylverbindung, die einen Siedepunkt über 180° aufweist und in der die Allylgruppe(n) über ein Sauerstoff-, Schwefel- und/oder Stickstoffatom gebunden ist (sind), enthalten ist.

Bei den solchen Fotolacken zur Verkürzung der Bestrahlungszeiten und zur Steigerung der Photopolymerisation zugesetzten strahlungsreaktiven, polymerisierbaren Allylverbindungen handelt es sich um Verbindungen oder deren Gemische, die vorzugsweise flüssig sind, aber auch fest sein können, einen Siedepunkt über 180°, vorzugsweise über 200° aufweise und ein oder mehrere Allylgruppen, die über ein Sauerstoff-, Schwefel- und/oder Stickstoffatom an das Grundgerüst des Moleküls gebunden sind, enthalten. Die Allylgruppen können beispielsweise etherartig über ein Sauerstoff- oder Schwefelatom an das jewellige Grundmolekül gebunden sein. Als Grundmoleküle, in denen eine oder mehrere Hydroxygruppen mit Allylalkohol und/oder Allylthiol verethert sind und die ihrerseits auch mit einer Säure verestert sein können, kommen beispielsweise mehrwertige aliphatische, alicyclische oder aromatische Alkohole in Frage. Bevorzugt sind dabei aliphatische mehrwertige Alkohole, in denen die Kohlenstoffkette gerad- oder verzweigtkettig sein kann und 2 bis 8 C-Atome enthält. Dabei kann die Kohlenstoffkette auch ungesättigt und/oder gegebenenfalls durch Heteroatome wie Sauerstoff, Schwefel oder Stickstoff unterbrochen und/oder substituiert sein. Als Substituenten kommen beispielsweise aromatische Gruppen, wie Phenyl, oder Ketogruppen in Frage. Insbesondere gehören zu solchen Alkoholen Ethylenglykol, 1,2- und 1,3-Propylenglykol, Glycerin, 1,2-, 1,3-, 1,4- und 2,4-Butandiol, 1,2,3- und 1,2,4-Butantriol, Erythrit, die Pentite wie Xylit, die Hexite wie Sorbit und Mannit, ferner auch Verzweigtkettige wie Di- und Trimethylolethan, Di- und Trimethylolpropan und Pentaerythrit. Ferner sind auch durch eine Phenylgruppe substituierte Alkohole dieser Gruppe Von Interesse, zum Beispiel Phenylethylenglykol, 1-Phenyl-2,3-dihydroxypropan 1-Phenyl-1,2-dihydroxypropan, 1- oder 2-Phenylglycerin und 1-Phenyl-butandiol-(2,4). Ferner sind auch alicyclische Alkohole bevorzugt, insbesondere solche, in denen die Kohlenstoffkette durch Heteroatome unterbrochen ist, wie beispielsweise im Triazintriol.

Weiterhin kann die Allylgruppe etherartig über ein Schwefelatom gebunden sein. Unter Schwefelatom sollen hier auch die -SO- und -SO$_2$-Gruppe verstanden werden.

Ferner können die Allylgruppen auch esterartig über ein Sauerstoff- oder Schwefelatom gebunden sein. Hier kommen insbesondere die entsprechenden von Benzoesäure, Phthalsäure, Terephthalsäure, Pyromellithsäure abgeleiteten Verbindungen in Frage. Ferner können die Allylgruppen vorzugsweise auch über ein Stickstoffatom gebunden sein. Solche Verbindungen, in denen ein bis alle vorhandenen Stickstoffatome durch Allylgruppen substituiert sein können, leiten sich vorzugsweise von fünf- und sechsgliedrigen, ein oder mehrere Stickstoffatome sowie gegebenenfalls weitere Heteroatome enthaltenden, gesättigten oder ungesättigten Ringsystemen sowie deren Derivaten ab. Als Beispiele für solche "Grundgerüste" seien genannt Pyrrol, Pyrrolin, Pyrrolidin, Pyrazol, Pyrazolin, Pyrazolidin, Imidazol, Imidazolin, Imidazolidin, Oxazolidin, Thiazolidin, Triazol, Piperidin, 1,4-Dihydropyridin, Piperazin, Triazin, Isocyanursaure sowie Derivate solcher stickstoffhaltiger Verbindungen. Ferner können die Allylgruppen auch über ein Amid- oder Imid-Stickstoffatom gebunden sein. Hier eignen sich besonders die entsprechenden Derivate der Benzoesäure, Phthalsäure, Terephthalsäure, Pyromellithsäure, Benzophenon-3,4-dicarbonsäure, Benzophenon-3,4,3'4'-tetracarbonsäure, Fumarsäure, Maleinsäure sowie weiterer Mono- und Dicarbonsäuren. Dabei kann das Amid-Stickstoffatom ein oder zwei Allylgruppen tragen. In Dicarbonsäuren können ein oder beide Säuregruppen als Amidgruppe vorliegen; in Monoamiden kann die verbleibende Säuregruppe auch verestert sein.

Als besonders bevorzugte erfindungsgemäß einsetzbare, strahlungsreaktive, polymerisierbare Allylverbindungen Seien genannt: Allylphenylether, Glycerindiallylether, Erythrittriallylether, Trimethylolpropandi- und -triallylether, Pentaerythritdi-, -tri- und -tetraallylether, Benzoesäure-(pentaerythrittriallylether)-ester, Phthalsäure-(pentaerythrittrlallylether)-mono- und -diester, Terephthalsäure-(pentaerythrittriallylether)-mono- und -diester, Pyromellithsäure-(pentaerythrittriallylether)mono-, -di-, -tri- und -tetraester, Diallylsulfoxid, Diallylsulfon, Allylbenzoat, Mono- und Diallylphthalat, Mono-, Di-, Tri- und Tetraallylpyromellithsäureester, Allylphenylthioether, 2,4,6-Trisallyloxy-1,3,5-triazin, 2,4-Diallyloxyimidazolidin, N-Allylpyrrol, N-Allylimidazol, N-Allylpiperidin, N,N-Diallylpiperazin, N,N,N-Triallyltriazin, 2,4,8-Tris(allylamino)-triazin, Triallyl-s-triazin-2,4,6-(1H,3H,5H)-trion, Hexaallylmelamin, N,N'-Diallylpyromellithbisimid, N,N'-Diallyl-benzophenon-3,4,3'4'-tetracarbonsäurebisimid, N-Allylphthalimid, N-Monoallyl- und N,N-Diallylbenzoesäureamid, N,N-Diallyl-fumarsäuremonoamid, N,N-Diallylmaleinsäuremonoamid, N,N,N',N'-Tetraallylfumarsäurebisamid, N,N-Diallylfumarsäuremonoamid-monoethylester sowie Gemische solcher Verbindungen.

Die lösliche, polymere Vorstufen enthaltenden Fotolacke enthalten erfindungsgemäß in der Regel zusätzlich 3 bis 30 Gew.%, vorzugsweise mindestens 10 Gew,%, insbesondere mindestens 15 Gew.%, bezogen auf die lösliche polymere Vorstufe, an strahlungsreaktiven, polymerisierbaren Allylverbindungen; in speziellen Fallen kann der Zusatz an strahlungsreaktiven, polymerisierbaren Alkylverbindungen auch mehr als 30 Gew.%, betragen.

Die in den erfindungsgemäßen Fotolacken enthaltenen löslichen polymeren Vorstufen entsprechen den üblichen löslichen polymeren Vorstufen, die sich durch Bestrahlen und gegebenenfalls Tempern in hochwärmebeständige Polymere überführen lassen. Solche löslichen polymeren Vorstufen sind beispielsweise in den DE-A- 23 08 830 DE-A- 24 37 348, DE-A- 24 37 368, DE-A- 24 37 422 und der am 26 januar 1984 veröffentlichten DE-A- 32 27 584 beschrieben.

Dabei handelt es sich in der Regel um Polyadditions- bzw. Polykondensationsprodukte aus einer Ringverbindung I, die zwei esterartig an Carboxylgruppen gebundene strahlungsreaktive Gruppen sowie zwei für Additions- oder Kondensationsreaktionen geeignete Carboxyl-, Carbonsäurechlorid-, Amino-, Isocyanat- oder Hydroxylgruppen bzw. durch einfache Reaktionen in solche umwandelbare Gruppen enthält, und einer geeigneten Ringverbindung II mit mindestens einem cyclischen Strukturelement, wie einem Diamin, einem Diisocyanat, einer Dicarbonsäure oder einem Bissäurechlorid. Als Ringverbindungen I werden erfindungsgemäß Polycarbonsäuren, insbesondere mit vier Carboxylgruppen, oder ihre Anhydride, Säurehalogenide und Partialester, wie Pyromellithsäure oder Bicyclo[2.2.2]-octen-(7)-tetracarbonsäure (2,3,S,6) oder deren Derivate, aber auch Dihydroxycarbonsäuren wie Bis-(4-hydroxy-3-carboxy-phenyl)-methan oder Diaminodicarbonsäuren wie 4,4'-Diamino-3,3'-Dicarboxybiphenyl verwandt. Unter diesen ist Pyromeilithsäure wegen ihrer leichten Zugänglichkeit und ihrer hohen chemischen Stabilität besonders bevorzugt. Sie wird vorzugsweise in die Synthesen der löslichen polymeren Vorstufen in Form ihres Dianhydrids eingesetzt.

Als Ring verbindungen II in den erfindungsgemäß einsetzbaren löslichen polymeren Vorstufen kommen alle bisher für diesen Zweck eingesetzten in Frage, wobei die Natur der funktionellen Gruppen von der für die Polyadditions- oder Polykondensationsreaktion zur Verfügung stehenden Gruppen in den Ringverbindungen I abhängt. So werden beispielsweise Säurechloridgruppen in den Ringverbindungen I bevorzugt mit Diaminen umgesetzt, Carbonsäuregruppen, Aminogruppen und Hydroxygruppen mit Diisocyanaten, Aminogruppen auch mit Bis-Säurechloriden, Isocyanatgruppen mit Dicarbonsäuren.

Besonders bevorzugt als lösliche polymere Vorstufen sind Polykondensate aus Pyromellithsäure, die zwei esterartig an Carboxylgruppen gebundene strahlungsreaktive Reste trägt, und einem mindestens ein cyclisches Strukturelement enthaltenden Diamin, wie beispielsweise 4,4'-Diaminodiphenylether, 4,4'-Diaminodiphenylmethan, 4,4'-Diaminodiphenylsulfon, 2,4-Diaminopyridin.

Diese löslichen polymeren Vorstufen enthalten esterartig an Carboxylgruppen gebundene strahlungsreaktive Reste. Auch diese Estergruppen sind bekannt, beispielsweise aus den DE-A- 23 08 830, DE-A- 24 37 348, DE-A- 24 37 422 und der am 29 januar 1984 veröffentlichten DE-A- 32 27 584.

Dabei sind besonders esterartig an Carboxylgruppen gebundene strahlungsreaktive Oxyallyl-, Oxyalkylacrylat- und Oxyalkylmethacrylatgruppen, wie 2-Oxyethylacrylatoder -methacrylatgruppen, ferner die in der am 26 januar 1984 veröffentlichten DE-A- 32 27 584 beschriebenen Allyloxy- und/oder Allylthiogruppen enthaltenden Estergruppen bevorzugt.

Die in den erfindungsgemäßen Fotolacken enthaltenen löslichen polymeren Vorstufen haben in der Regel Molekulargewichte zwischen 2 000 und 100 000, vorzugsweise zwischen 4 000 und 60 000.

Die Herstellung der in den erfindungsgemäßen Fotolacken enthaltenen löslichen polymeren Vorstufen ist ebenfalls bekannt, beispielsweise aus der DE-A- 23 08 830 und der am 26 januar 1984 veröffentlichten DE-A- 32 27 584. In der Regel werden dabei zunächst in den Ringverbindungen I zwei Carboxylgruppen unter für derartige Reaktionen üblichen Bedingungen mit den die strahlungsreaktiven Reste tragenden Alkoholen verestert. Der erhaltene Diester aus Ringverbindung I und dem (den) die strahlungsreaktive(n) Gruppe(n) einführenden Alkohol(en) wird anschließend, gegebenenfalls nach Modifizierung der noch freien funktionellen Gruppen, mit einer Ringverbindung II in einer an sich bekannten Polyadditions- oder Polykondensationsreaktion zu der löslichen polymeren Vorstufe umgesetzt. Diese Umsetzungen erfolgen vorzugsweise unter den in den oben erwähnten Druckschriften beschriebenen Reaktionsbedingungen. Aus dem Reaktionsgemisch wird die lösliche polymere Vorstufe in herkömmlicher Weise abgetrennt, zum Beispiel durch Ausfällen mit Wasser und Abfiltrieren und gegebenenfalls gründlichem Auswaschem nicht gewünschter Nebenprodukte.

Diese löslichen polymeren Vorstufen und die erfindungsgemäß zuzusetzenden strahlungsreaktiven, polymerisierbaren Allylverbindungen werden in an sich bekannter Weise zu den erfindungsgemäßen Fotolacken verarbeitet. Diese Fotolacke können außer einem geeigneten Lösungsmittel, der löslichen polymeren Vorstufe und der (den) Allylverbindung(en) weitere in dieser Technologie bekannte und übliche Zusatzstoffe enthalten. Als Beispiele seien Füllstoffe, Fotosensibilisatoren, wie beispielsweise 4,4'-Bis(dimethylamino)-benzophenon (Michlers Keton), 4,4'-Bis(diethylamino)-benzophenon, Benzoinether, Anthrachinon- oder Thioxanthon-Derivate, ferner auch copolymerisierbare, strahlungsempfindliche Maleinimide wie beispielsweise N-Phenylmaleinimid, Farbstoffe, Pigmente, Weichmacher, Haftvermittler, wie beispielsweise Vinylsilane, thermisch aktivierbare, freie Radikale bildende Initiatoren genannt, ferner auch die verschiedensten anderen Polymeren und Harze, Stabilisatoren sowie oberflachenaktive Verbindungen, die gegebenenfalls zur Verbesserung der filmbildenden Eigenschaften oder Beschichtungseigenschaften beitragen können und/oder zur Verbesserung der Haftung der auf die Substrate aufgetragenen Schichten, ferner zur Verbesserung der mechanischen Festigkeit, der chemischen Widerstandsfähigkeit, der Fließbeständigkeit des Materials, aber auch zur Beeinflussung der Viskosität der Fotolacke. Solche Zusatzstoffe können in einer Menge von 0 bis 15 Gew.%, bezogen auf den Feststoffgehalt, zugesetzt werden.

Als Lösungsmittel, die die löslichen polymeren Vorstufen und die vorgenannten Bestandteile der Fotolacke lösen können, eignen sich beispielsweise Ethylenglykol, Glykolether wie Glykolmonomethylether, Glykoldimethylether und Glykolmonoethylether; aliphatische Ester wie Ethylacetat, Hydroxyethylacetat, Alkoxyethylacetat, n-Butylacetat oder Amylacetat; Ether wie Dioxan; Ketone wie Methylethylketon, Methyl-iso-butylketon, Cyclopentanon und Cyclohexanon; Dimethylformamid, Dimethylacetamid, Hexamethylphosphorsäuretriamid, N-Methylpyrrolidon, Butyrolacton, Tetrahydrofuran und Mischungen solcher Lösungsmittel. Diese Lösungen enthalten in der Regel 5 bis 60 %, vorzugsweise bis 50 % an Feststoffen. Die erfindungsgemäßen Fotolacke können in der üblichen Weise auf alle hierfür gebräuchlichen Substrate aufgetragen werden, insbesondere auf an der Oberfläche thermisch oxidierte und/oder mit Aluminium beschichtete Siliziummaterialien, die gegebenenfalls auch dotiert sein können, ferner alle anderen in der Halbleitertechnologie üblichen Substrate wie z. B. Siliziumnitrid, Galliumarsenid, Indiumphospid. Weiterhin kommen infrage aus der Flüssigkristalldisplay-Herstellung bekannte Substrate wie Glas, Indium-Zinn-oxid; ferner Metallplatten und -folien, beispielsweise aus Aluminium, Kupfer, Zink; Bimetall- und Trimetallfolien, aber auch elektrisch nicht leitende Folien, die mit Metallen bedampft sind, gegebenenfalls mit Aluminium beschichtete $SiO_2$-Materialien, Papier. Diese Substrate können einer Temperatur-Vorbehandlung unterzogen werden, oberflächlich angerauht, angeätzt oder zur Erhöhung der Hydrophilie mit Chemikalien behandelt sein.

Die Fotolackschichten können in verschiedener Stärke auf ein Substrat aufgetragen werden. Die im Einzelfalle vorteilhafteste Schichtstärke hängt von verschiedenen Faktoren ab, beispielsweise dem speziellen Verwendungszweck des herzustellenden Materials, der im Einzelfalle verwendeten polymeren Vorstufe und der Natur der anderen Komponenten, die gegebenenfalls in der strahlungsempfindlichen Schicht zugegen sein können. Als zweckmäßig hat es sich in der Regel erwiesen, wenn die Resistschichten eine Stärke von 0, 1 µm bis 20 µm aufweisen.

Der Auftrag der Fotolacke auf die saubere Oberfläche der Substrate kann durch Aufsprühen, Fließbeschichten, Walzen, Schleuderbeschichten und Tauchbeschichten erfolgen, wonach das Lösungsmittel durch Verdampfen entfernt wird, so daß auf der Oberfläche des Substrats eine strahlungsempfindliche Schicht zurückbleibt. Die Entfernung des Lösungsmittels kann gegebenenfalls durch Erhitzen der Schicht auf Temperaturen von bis zu 100° gefördert werden. Anschließend wird die Fotolackschicht der Strahlung ausgesetzt, welche die Reaktion der strahlungsreaktiven Gruppen unter Vernetzung der Schicht verursacht. Üblicherweise wird aktinisches Licht verwendet, aber auch energiereiche Strahlung wie Röntgen- oder Elektronenstrahlung. Die Bestrahlung oder Belichtung kann durch eine Maskenvorlage durchgeführt werden, es kann aber auch ein gebündelter Strahl der Strahlung über die Oberfläche der strahlungsempfindlichen Schicht geführt werden. Üblicherweise werden zur Bestrahlung UV-Lampen verwendet, die Strahlung einer Wellenlänge von 200 bis 500 nm und einer Intensität von 0,5 bis 60 mW/cm$^2$ aussenden. In der Schicht wird ein Bildmuster unter Freilegung von Teilen des Substrats entwickelt, indem die Schicht mit einer Entwicklerlösung behandelt wird, die die nicht bestrahlten Bereiche des Fotolackmaterials entfernt.

Als Entwicklerlösung wird in der Regel ein Gemisch aus einem oder mehreren der für die Herstellung des Fotolacks angegebenen Lösungsmittel mit einem Fällungsmittel verwendet. Typische Entwicklerlösungen sind beispielsweise 4-Butyrolacton/Toluol, Dimethylformamid/Ethanol, Dimethylformamid/Methanol, Methylethylketon/Ethanol und Methyl-i-butylketon/i-Propanol, jeweils in Verhältnis 2:1 bis 1:4. Nach kurzer Bestrahlungsdauer, die in der Regel mindestens um den Faktor 3 bis 4 kürzer ist als bei den entsprechenden Fotolacken ohne den erfindungsgemäßen Zusatz mindestens einer Allylverbindung,sowie Entwickeln, Waschen und Trocknen, werden kantenscharfe Resistbilder mit einer Auflösung von unter 3 μm erhalten, die durch Tempern bei 200 bis 400° in hochwärmebeständige Polymere überführt werden können.

Diese hochwärmebeständigen Polymeren haben ausgezeichnete chemische, elektrische und mechanische Eigenschaften. Die erfindungsgemäßen Fotolacke eignen sich somit beispielsweise zur Herstellung von Schutzschichten auf Halbleiterelementen, dielektrischen Schichten bei vielschichtigen integrierten Schaltungen, als letzte passivierende Schicht auf elektrischen Vorrichtungen sowie als Grientierungsschicht von Flüssigkristallanzeigezellen. Die folgenden Beispiele erläutern die Herstellung der erfindungsgemäßen Fotolacke und ihre Anwendung.

**Beispiel 1**

a) Fotolack
5 g polymere Vorstufe (erhalten durch Umsetzung von Pyromellithsäuredianhydrid mit (2-Hydroxyethyl)-methacrylat und anschließend mit Thionylchlorid und 4,4'-Diaminodiphenylether gemäß der DE-A- 24 37 348)
0,25 g N-Phenyl-maleinimid
0,1 g Michlers Keton
0,05 g Vinyltrimethoxysilan und
0,5 g Pentaerythrittriallylether
werden in 13,5 ml Dimethylacetamid gelöst.
b) Anwendung
ein Substrat mit einer SiO$_2$-Oberfläche wird

der Fotolack gemäß (a) aufgeschleudert und durch Erwärmen getrocknet. Die erhaltene 1,5 μm starke Schicht wird anschließend unter Stickstoff im Kontaktverfahren 50 Sekundewn durch ein Strichraster mit einer 200 Watt UV-Lampe mit einer Intensität von 5 - 6 mW/cm$^2$ bestrahlt.

Anschließend werden die nicht bestrahlten Fotolackteile durch Entwickeln mit einer Mischung aus gleichen Volumenteilen Toluol und 4-Butyrolac-ton ausgewischen. Man erhält ein kantenscharfes Bild mit einer Auflösung von weniger als 3 μm.

**Beispiel 2**

a) Fotolack
5 g polymere Vorstufe (erhalten durch Umsetzung von Pyromellithsäuredianhydrid mit (2-Hydroxyethyl)-methacrylat und anschließend mit Thionylchlorid und 4,4'-Diaminodiphenylether gemäß der DE-A- 24 37 348)
0,25 g N-Phenyl-maleinimid
0,1 g Michlers Keton
0,05 g Vinyltrimethoxysilan und
1 g Pentaerythrittriallylether
werden in 13,5 ml Dimethylacetamid gelöst.
b) Anwendung
Analog Beispiel 1 b) erhält man nach einer Bestrahlungsdauer von 35 Sekunden ein identisch kantenscharfes Bild mit einer Auflösung von weniger als 3 μm.

**Beispiele 3 bis 18**

Analog Beispiel 1 werden folgende Fotolacke hergestellt:
5 g polymere Vorstufe (wie in Beispiel 1 beschrieben)
0,25 g N-Phenyl-maleinimid
0,1 g Michlers Keton
0,05 g Vinyltrimethoxysilan und
1 g strahlungsreaktive, polymerisierbare Allylverbindungen
werden in 13,5 ml Dimethylformamid gelöst.
Als strahlungsreaktive, polymerisierbare Allylverbindungen werden eingesetz:
Beispiel 3 Allylphenylether
Beispiel 4 Glycerindiablylether
Beispiel 5 Gemisch aus Pentaerythritdi-, -tri- und -tetraallylether
Beispiel 6 Pyromellithsäure(pentaerythrittriallylether)-diester
Beispiel 7 Gemisch aus Pyromellithsäure(pentaerythrittriallylether)tri- und -tetraester
Beispiel 8 Allylphenylthioether
Beispiel 9 Dialkylsulfoxid
Beispiel 10 Diallylsulfon
Beispiel 11 2,4,5-Trisallyloxy-1,3,5-triazin
Beispiel 12 Triallyl-s-triazin-2,4,6-(1H,3H,5H)-

trion
Beispiel 13 Allylimidazol
Beispiel 14 N-Allyl-benzoesäureamid
Beispiel 15 N,N-Diallyl-benzoesäureamid
Beispiel 16 N,N-Diallyl-maleinsäuremonoamid
Beispiel 17 N,N-Diallyl-fumarsäuremonoamidmonoethylester
Beispiel 18 N,N,N',N'-Tetraallyl-fumarsäurediamid

Bei einer Anwendung analog Beispiel 1 b) erhält man nach Bestrahlung jeweils kantenscharfe Bilder mit einer Auflösung von weniger als 3 μm.

**Beispiel 19**

a) Herstellung der polymeren Vorstufe
Eine Lösung von 18,5 g Pyromellithsäuredianhydrid, 8,7 g Pentaerythrittriallylether und 17,6 g (2-Hydroxyethyl)-methacrylat in 200 ml Tetrahydrofuran wird unter Rühren und Wasserkühlung bei Raumtemperatur allmählich mit 28 ml Pyridin versetzt, und das Reaktionsgemisch wird 3 Tage bei Raumtemperatur stehengelassen. Anschließend wird unter kräftigem Rühren langsam 12 ml Thionylchlorid bei -10° bis -15° zugetropft und 3 Stunden bei der gleichen Temperatur nachgerührt. Zum Reaktionsgemisch wird dann bei -10° bis -15° eine Lösung von 13,5 g 4,4'-Diaminodiphenylether in 65 ml Dimethylacetamid getropft. Die Mischung wird über Nacht bei Raumtemperatur gerührt und anschließend mit wenig Acetylchlorid sowie mit etwa 50 ml Ethanol versetzt. Nach dem stehen über Nacht wird die Lösung in 4 1 Wasser eingerührt, das abgesaugte Präpolymere mit Wasser gewaschen und im Vakuum getrocknet.

In dieser polymeren Vorstufe liegt etwa 80 % der esterartig an Carboxylgruppen gebundenen strahlungsraktiven Reste (2-Hydroxyethyl)-methacrylat und etwa 20 % Pentaerythrittriallylether zugrunde.
b) Fotolack
5 g polymere Vorstufe nach (a)
0,25 g N-Phenyl-maleinimid
0,1 g Michlers Keton
0,05 g Vinyltrimethoxysilan und
0,5 g Pentaerythrittriallylether
werden in 13,5 ml Dimethylacetamid gelöst.
Bei einer Anwendung analog Beispiel 1 b) erhält man nach einer Bestrahlungsdauer von 30 Sekunden ein kantenscharfes Bild mit einer Auflösung von weniger als 3 μm.

**Vergleichsbeispiel**

Analog Beispiel 1 wird folgender bekannter Fotolack hergestellt:
5 g polymere Vorstufe (wie in Beispiel 1 beschrieben)
0,25 g N-Phenyl-maleinimid
0,1 g Michlers Keton und
0,05 g Vinyltrimethoxysilan
werden in 13,5 ml Dimethylacetamid gelöst.
Bei der Anwendung analog Beispiel 1 b) muß die Bestrahlungsdauer auf mindestens 180 sekunden erhöht werden, um ein kantenscharfes Bild zu erhalten.

**Patentansprüche**

1. Fotolacke zur Ausbildung von Reliefstrukturen aus hochwärmebeständigen Polymeren, enthaltend esterartig an Carboxylgruppen gebundene strahlungsreaktive Reste tragende, lösliche polymere Vorstufen, dadurch gekennzeichnet, daß zusätzlich mindestens eine strahlungsreaktive, polymerisierbare Allylverbindung, die einen siedepunkt über 180° aufweist und in der die Allylgruppe(n) über ein sauerstoff-, schwefel- und/oder stickstoffatom gebunden ist (sind), enthalten ist.

2. Verwendung von strahlungsreaktiven, polymerisierbaren Allylverbindungen, die einen Siedepunkt über 180° aufweisen und in denen die Allylgruppe(n) über ein Sauerstoff-, Schwefel- und/oder Stickstoffatom gebunden ist (sind), in Fotolacken zur Ausbildung von Reliefstrukturen aus hochwärmebeständigen Polymeren, enthaltend esterartig an Carboxylgruppen gebundene strahlungsreaktive Reste tragende, lösliche polymere Vorstufen.

3. Verfahren zur Herstellung von Reliefstrukturen aus hochwärmebeständigen Polymeren durch Auftragen von Fotolacken, enthaltend esterartig an Carboxylgruppen gebundene strahlungsreaktive Reste tragende, lösliche polymere Vorstufen, in Form einer schicht oder Folie auf ein substrat, Trocknen der schicht oder Folie, Bestrahlen der strahlungsempfindlichen schicht oder Folie durch Negativvorlagen, Herauslösen oder Abziehen der nicht bestrahlten Schicht- oder Folienteile und gegebenenfalls anschließendes Tempern der erhaltenen Reliefstrukturen, dadurch gekennzeichnet, daß man Fotolacke nach Anspruch 1 verwendet.

**Claims**

1. Photoresists for forming relief structures of highly heat-resistant polymers and containing soluble polymeric precursors which carry radiation-reactive radicals bonded ester-like to carboxyl groups, characterised in that they also contain at least one radiationreactive polymerisable allyl compound which has a boiling point above 180° and in which the allyl group(s) is (are) bonded via an oxygen, sulfur and/or nitrogen atom.

2. Use of radiation-reactive polymerisable allyl compounds which have a boiling point above 180° and in which the allyl group(s) is (are) bonded via an oxygen, sulfur and/or nitrogen atom, in photoresists for forming relief structures of highly heat-resistant polymers and containing soluble polymeric precursors which carry radiation-reactive radicals bonded ester-like to carboxyl groups.

3. Process for preparing relief structures of highly heat-resistant polymers by applying photoresists containing soluble polymeric precursors which carry radiation-reactive radicals bonded ester-like to carboxyl groups in the form of a film or sheet to a substrate, drying the film or sheet, irradiating the radiation-sensitive film or sheet through negative originals, dissolving out or peeling off the non-irradiated parts of the film or sheet and, if appropriate, subsequently heat-treating the relief structures obtained, characterised in that photoresists according to Claim 1 are used.

**Revendications**

1. Laques photographiques pour la formation de structures de reliefs constituées de polymères résistant à des températures élevées, contenant des produits préliminaires polymères solubles et portant des radicaux réactifs aux rayonnements, fixés à la manière d'ester sur des groupes carbonyle caractérisées par le fait qu'elles contiennent en plus au moins un composé allylique polymérisable réactif aux rayonnements, présentant un point d'ébullition supérieur à 180 ° et dans lequel le/les groupe(s) allyle(s) est (sont) lié(s) par l'intermédiaire d'un atome d'oxygène, de soufre et/ou d'azote.

2. Utilisation de composés allyliques réactifs aux rayonnements, polymérisables, présentant un point d'ébullition supérieur à 180 ° et dans lesquels le/les groupe(s) allyle(s) est (sont) lié(s) par l'intermédiaire d'un atome d'oxygène, de soufre et/ou d'azote, dans des laques photographiques pour la formation de structures de reliefs à partir de polymères résistant à des températures élevées, contenant des produits préliminaires polymères solubles et portant des radicaux réactifs aux rayonnements, fixés à la manière d'ester sur des groupes carbonyle.

3. Procédé pour la fabrication de structures de reliefs à partir de polymères résistant à des températures élevées par le dépôt de laques photographiques, contenant des produits préliminaires polymères solubles et portant des radicaux réactifs aux rayonnements, fixés à la manière d'ester sur des groupes carbonyle, sous la forme d'une couche ou d'une feuille sur un substrat, séchage de la couche ou de la feuille, irradiation de la couche ou de la feuille sensible aux rayonnements par des originaux négatifs, enlèvement ou arrachage des parties non irradiées de la couche ou de la feuille et le cas échéant, chauffage final des structures de reliefs obtenues, caractérisé par le fait que l'on utilise les laques photographiques selon la revendication 1.